Europäisches Patentamt

European Patent Office

Office européen des brevets

(11) Numéro de publication: **0 225 215 B1**

(12) **FASCICULE DE BREVET EUROPEEN**

(45) Date de publication de fascicule du brevet:
02.05.91

(51) Int. Cl.⁵ **H04R 1/02, H05K 9/00**

(21) Numéro de dépôt: **86402341.1**

(22) Date de dépôt: **17.10.86**

(54) Perfectionnements aux enceintes acoustiques et équipements associés.

(30) Priorité: **18.10.85 FR 8515485**

(43) Date de publication de la demande:
**10.06.87 Bulletin 87/24**

(45) Mention de la délivrance du brevet:
**02.05.91 Bulletin 91/18**

(84) Etats contractants désignés:
**DE ES GB IT NL**

(56) Documents cités:
**WO-A-85/03187**
**FR-A- 2 437 686**
**GB-A- 2 057 297**
**US-A- 3 191 132**
**US-A- 3 436 467**

(73) Titulaire: **P S I**
**62 Rue Cavé**
**F-92300 Levallois Perret(FR)**

(72) Inventeur: **Noel, Gérard Philippe Alain**
**148 Avenue du Président Wilson**
**F-92300 Levallois Perret(FR)**

(74) Mandataire: **CABINET BONNET-THIRION**
**95 Boulevard Beaumarchais**
**F-75003 Paris(FR)**

EP 0 225 215 B1

## Description

La présente invention a trait à un perfectionnement aux transducteurs électroacoustiques, et notamment aux enceintes acoustiques et équipement associés.

Il est bien connu que les performances quantitatives, tel le rendement, ou encore le niveau admissible, des transducteurs électroacoustiques ne donne qu'une idée très partielle des performances globales de ces transducteurs.

Pour de nombreuses raisons bien connues, il est souhaitable que les transducteurs reproduisent les signaux qui leurs sont donnés avec autant d'exactitude que possible.

Une des sources d'inexactitude dans la reproduction des signaux par des transducteurs est le parasitage de ces signaux par d'autres.

Des signaux parasites, émanant de diverses sources généralement incontrôlées, peuvent aisément être captés par les câbles et connecteurs divers associés aux transducteurs, et se combiner aux signaux qui y circulent.

Ces parasites contribuent à perturber l'exactitude de la reproduction, ce qui constitue bien évidemment un inconvénient important dans la qualité du signal obtenu.

Un but de la présente invention est de remédier à cet inconvénient.

Un autre but de la présente invention est de présenter une enceinte acoustique offrant des performances qualitatives supérieures à celles des enceintes acoustiques traditionnelles.

On a déjà cherché par divers moyens à supprimer les rayonnements parasites perturbateurs dans différents domaines et proposé, notamment dans FR-A-2 437 686, un élément électrique à pertes du genre fil, câble ou écran électrique comportant au moins un élément conducteur combiné avec un mélange absorbant magnétique.

L'invention propose une enceinte acoustique du genre comportant un ou plusieurs haut-parleurs disposés dans un coffret de telle façon qu'une partie dite de radiation de ces haut-parleurs puisse irradier une pression acoustique à l'extérieur du coffret, enceinte dotée, en vue de la protection contre les rayonnements parasites, d'au moins un élément électrique à pertes, caractérisée en ce que ledit élément électrique à pertes est constitué par un écran de revêtement ou de gainage, d'au moins certains et de préférence tous ses éléments constituants, tels que :

- câbles conducteurs connectant les haut-parleurs à un connecteur général ;
- l'aimant de chaque haut-parleur ;
- une lèvre d'appui en saillie radiale de chaque haut-parleur ;
- parois du coffret ;

ledit écran étant réalisé en un matériau diélectrique dont la résistivité et la constante diélectrique se combinent par multiplication en une constante de temps spécifique supérieure à $2.10^{15}$ secondes.

La demanderesse a constaté, à l'issue d'expériences pratiques, l'amélioration de la qualité de la restitution sonore obtenue par une mise en oeuvre de cette disposition. L'amélioration constatée concerne notamment l'absence de parasitage du signal, ce qui permet d'atteindre une clarté sonore supérieure à celle obtenue à l'aide d'enceintes acoustiques de l'art antérieur.

Selon un autre aspect de l'invention, l'un au moins des hauts-parleurs de l'enceinte comporte un revêtement électriquement conducteur, en pratique une métallisation annulaire partielle de la membrane, ce revêtement étant connecté électriquement à l'une des bornes de connexion dudit haut-parleur.

La demanderesse a en effet constaté que cette disposition améliore les performances qualitatives de l'enceinte en favorisant l'émission du signal utile par le haut-parleur, tandis que l'écran en évite le parasitage par des signaux d'autre nature.

Par ailleurs l'application des écrans diélectriques à haute constante de temps spécifique selon l'invention est avantageusement étendue en amont de l'enceinte proprement dite aux divers équipements associés à celle-ci.

Un mode de réalisation préférentiel de l'invention va être décrit ci-après de façon détaillée, en référence aux dessins annexés, dans lesquels:

la figure 1 est une vue en coupe verticale d'une enceinte acoustique selon l'invention, et

la figure 2 est une vue en coupe méridienne d'un haut-parleur constituant un élément d'une enceinte selon l'invention.

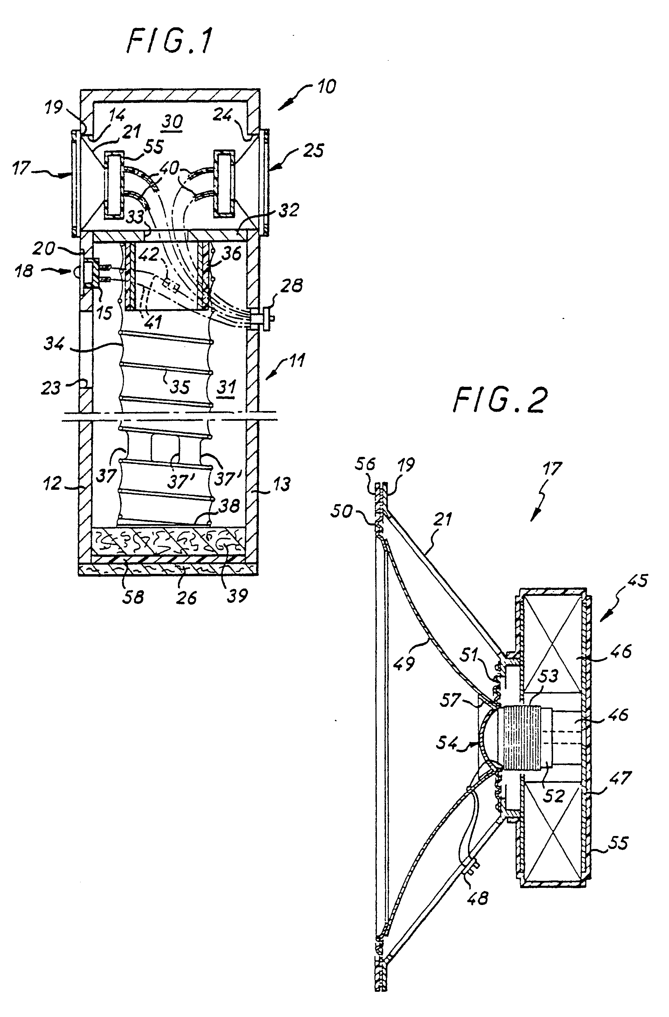

Plus en détail, en référence à la figure 1, une enceinte acoustique 10 selon l'invention comprend un coffret 11 sensiblement en forme de parallélipipédique rectangle, dont une paroi 12, dite frontale est percée de trois orifices:

Deux défonçages 14 et 15 aptes à recevoir deux hauts-parleurs 17 et 18 respectivement, chaque haut-parleur étant muni d'une lèvre d'appui périphérique 19 et 20 respectivement, radialement en saillie d'un châssis 21, 22 respectivement, supportant l'ensemble des éléments constituant un haut-parleur.

Une fenêtre 23 mettant en communication l'intérieur et l'extérieur du coffret 11.

En pratique, les défonçages 14, 15 et la fenêtre 23 sont alignés dans cet ordre sur la paroi 12, dans un sens parallèle aux plus grands côtés de cette paroi.

Une paroi dite dorsale 13 du coffret 11, opposée et parallèle à la paroi frontale 12, est percée d'un défonçage 24, de même dimension que le défonçage 14 et symétrique à ce dernier par rapport à un plan médian parallèle aux deux parois 12 et 13 passant entre celles-ci.

Un haut-parleur 25, de préférence de même type que le haut-parleur 17, est disposé dans ce défonçage 24, une lèvre d'appui permettant sa fixation sur la paroi 13.

Les deux hauts-parleurs 17 et 25 sont en fait dos à dos, symétriquement par rapport au plan précité, chaque haut-parleur comprenant une partie dite frontale regardant vers l'extérieur du coffret, et une partie dite dorsale regardant vers l'intérieur du coffret.

Un haut-parleur de ce type, le haut-parleur 17 par exemple, sera décrit ultérieurement.

L'enceinte 10, telle que représentée, repose sur une base 26, à laquelle les deux parois 12 et 13 sont normales. En pratique, la base 26 est sensiblement horizontale, et les parois 12 et 13 sont sensiblement verticales.

La paroi 13 est percée à mi-hauteur d'un ajour 27 recevant un connecteur 28 à deux bornes, permettant d'établir deux contacts.

L'intérieur du coffret 11 est divisé en deux parties, une partie supérieure 30 et une partie inférieure 31.

La partie supérieure 30 est plus petite que la partie 31, une cloison 32 parallèle à la base 26, et percée d'une ouverture 33 sensiblement circulaire les séparant.

Une telle cloison 32 se raccorde aux parois verticales du coffret 11 à une hauteur située entre le défonçage 14 et le défonçage 15, et est jointive par sa tranche avec lesdites parois, par collage de préférence.

A la face inférieure de la cloison 32, concentriquement à l'ouverture 33, est fixé un tuyau souple 34 d'un diamètre légèrement supérieur à celui de l'ouverture 33.

La fixation de ce tuyau à la cloison 32 est étanche.

Le tuyau souple 34 est avantageusement renforcé d'une armature hélicoïdale 35.

Une portion de la hauteur du tuyau 34 est renforcée également d'un manchon de rigidification 36, interne à la partie haute du tuyau 34 jusqu'à sa liaison avec la cloison 32.

Un tel manchon comporte deux couches successives, de l'extérieur vers l'intérieur, respectivement l'une en matière plastique rigide (polyvinyl chlorure par exemple) et l'autre en liège.

A sa partie inférieure, le tuyau 34 est percé de quatre ouïes de décompression 37,37', 37'', 37''' (trois seulement sont visibles sur la figure 1) situés axialement entre deux spires de la nervure 35 et radialement sensiblement à 90° les uns des autres.

L'extrémité inférieure du tuyau 34 est obturée par une plaque 38, en carton dans le mode de réalisation décrit.

Le fond de l'enceinte est recouvert d'une couche 39 de matériau acoustiquement absorbant, de la laine de verre par exemple.

Les hauts-parleurs 17 et 25 sont connectés en parallèle au connecteur 28 par quatre conducteurs 40. Le haut-parleur 18, d'un genre différent des deux autres, particulièrement adapté à la reproduction des signaux les fréquences les plus élevées de la bande audible, dite aiguës, est connecté par un faisceau 41 de deux câbles conducteurs au connecteur 28. Le haut parleur 18 n'étant pas apte à reproduire les fréquences les plus basses sans risque de détérioration, un condensateur 42 lui est connecté en série.

Les faisceaux 40 et 41 sont tous deux gainés d'un matériau formant écran. Un tel matériau est choisi pour présenter une constante de temps spécifique particulièrement élevée, supérieure à $2 \times 10^{15}$.

Dans l'exemple de réalisation décrit, on utilise du polytétrafluoréthylène.

Il est également possible d'utiliser d'autres matériaux présentant une constante de temps spécifique du même ordre, par exemple du polytrifluorochloroéthylène, de l'éthylène propylène fluoré, certains polystyrènes très purs ou encore du titanate de Baryum.

Le haut-parleur 17, représenté plus en détail à la figure 2, est constitué globalement de deux parties, l'une fixe et l'autre mobile.

La partie fixe comprend un châssis 21 de forme sensiblement tronconique et ajourée, qui peut d'ailleurs être réduit à de simples branches reliant deux couronnes, selon le type de haut-parleur, connu en soi, mis en oeuvre.

La plus grande base du cône ainsi formé constitue la partie antérieure du haut-parleur, la partie postérieure étant liée à la plus petite base.

Le châssis 21 comporte, à sa partie antérieure, la lèvre d'appui 19, comme mentionné précédemment.

Sa partie postérieure supporte une culasse 45 constituée d'un aimant 46 à deux pôles concentriques, l'un cylindrique et l'autre annulaire l'entourant, et d'une plaque dite de champ 47, en forme de disque plat et qui recouvre la face postérieure de l'aimant 46. Le châssis 21 supporte également un bornier de connexion 48 à deux pôles.

La partie mobile du haut-parleur comporte une membrane 49, de forme globalement tronconique reliée par une première suspension périphérique à la partie antérieure du châssis 21, et par une deuxième suspension périphérique 51 à la partie postérieure du châssis 21.

La membrane est disposée à l'intérieur du châssis 21 et les deux suspensions sont aptes à lui permettre un débattement axial par rapport à celui-ci, tout en lui interdisant tout débattement en sens radial.

La petite base de la membrane, à laquelle est fixée la deuxième suspension 51, est prolongée axialement par un cylindre 52 supportant un bobinage 53 qui s'enroule autour, dans une configuration telle que ce bobinage pénètre dans l'espace, en pratique un entrefer, séparant les deux pôles concentriques de l'aimant 46.

Au niveau axial de la jonction entre la membrane et le cylindre 52 se trouve un dôme 54 réalisé, par exemple, dans le même matériau que la membrane 49, isolant acoustiquement une face de ladite membrane de l'autre, notamment lorsque la lèvre 19 est fixée à la paroi de l'enceinte 10.

Le bobinage 53 est connecté aux deux pôles du bornier 48 par ses deux extrémités.

Les structure du haut-parleur 17 décrite ci-avant en référence à la figure 2 est celle d'un haut-parleur classique.

Le haut-parleur 17 comporte, en plus de ces éléments classiques dans les hauts-parleurs du genre dit électrodynamiques, des particularités propres à la présente invention.

Un revêtement 55 en matériau à constante de temps spécifique supérieure à 2 x 10$^{15}$, en pratique le même que celui constituant le gainage des câbles 40, 41, entoure la culasse du haut-parleur.

Un anneau 56, en le même matériau, recouvre une face du côté antérieure de la lèvre 19.

Un revêtement annulaire 57 en matériau électriquement conducteur, par exemple métallique est ménagé sur la face antérieure de la membrane 21, axialement à proximité de la jonction de celle-ci avec le cylindre 52 supportant le bobinage 53.

Ce revêtement est connecté électriquement à l'un des pôles du bornier 48.

Les deux autres hauts-parleurs, 25 et 18 (figure 1) comportent également un revêtement 55 autour de leur culasse, et un anneau 56, recouvrant la lèvre d'appui, en le même matériau.

Le haut-parleur 25 comporte également un revêtement métallique fixé sur la membrane et connecté au bornier.

Le haut-parleur 18, destiné à reproduire les fréquences aiguës, ne comporte pas de revêtement métallique dans ce mode de réalisation, l'alourdissement de la partie mobile que cela constituerait étant susceptible de réduire son aptitude à la reproduction des signaux des fréquences les plus élevées.

Le fond 26 du coffret 11 est également revêtu d'un écran en le même matériau que celui utilisé pour le gainage des câbles 40 et 41.

En pratique, ce matériau est disposé en une couche 58 adhérisée à plat sur le fond du coffret, en dessous de la couche 39 de matériau absorbant.

Par ailleurs, l'application de tels écrans est avantageusement étendue en amont de l'enceinte, notamment au câble d'alimentation, à l'amplificateur et autres équipements (non représentés) qui peuvent y être associés.

Il a été constaté par la demanderesse que, dans tous les cas, la qualité des résultats obtenus était liée à la bonne adhérence du matériau formant écran à l'élément qu'il recouvre de manière à être solidarisé en vibrations avec celui-ci.

L'invention ne se limite pas, bien entendu, au mode de réalisation décrit, mais englobe toutes les variantes d'exécution qu'il appartiendra à l'homme de l'art d'envisager. Ainsi par exemple, la fenêtre 23 ménagée sur la paroi frontale 12 de l'enceinte peut être répétée sur la paroi dorsale 13 ; dans d'autres modes de réalisation il est envisagé de mettre en oeuvre un haut-parleur d'aigës comportant de par sa conception un élément actif en matériau électriquement conducteur auquel cas, selon l'invention, cet élément sera connecté à l'un des pôles du bornier 48.

## Revendications

1.  Enceinte acoustique (10) du genre comportant un ou plusieurs haut-parleurs (17) disposés dans un coffret (11) de telle façon qu'une partie dite de radiation (49) de ces haut-parleurs puisse irradier une pression acoustique à l'extérieur du coffret, enceinte dotée, en vue de la protection contre les rayonnements parasites, d'au moins un élément électrique à pertes, caractérisée en ce que ledit élément électrique à pertes est constitué par un écran de revêtement ou de gainage (55), d'au moins certains et de préférence tous ses éléments constituants, tels que :
    - câbles conducteurs (40, 41) connectant les haut-parleurs à un connecteur général ;
    - l'aimant (46) de chaque haut-parleur ;
    - une lèvre d'appui (56) en saillie radiale de chaque haut-parleur ;
    - parois (26) du coffret (11) ;
    ledit écran étant réalisé en un matériau diélectrique dont la résistivité et la constante diélectrique se combinent par multiplication en une constante de temps spécifique supérieure à 2.10$^{15}$ secondes.

2.  Enceinte acoustique selon la revendication 1, dont l'un au moins des haut-parleurs comporte un revêtement électriquement conducteur (57) sur au moins une partie de sa membrane, caractérisée en ce que ledit revêtement est connecté électriquement à l'une des bornes de connexion (48) dudit haut-parleur.

3. Enceinte acoustique selon la revendication 2, caractérisée en ce que ledit revêtement est métallique.

4. Equipements associés à une enceinte selon l'une quelconque des revendications précédentes, caractérisés par le fait qu'au moins un de leurs éléments est recouvert d'un écran tel que défini dans la revendication 1.

5. Ecran tel que défini dans la revendication 1, caractérisé en ce que son matériau constitutif est choisi dans le groupe comportant le polytétrafluoréthylène, l'éthylène propylène fluoré, un polystyrène très pur, du titanate de baryum.

## Claims

1. Acoustic enclosure (10) of the kind comprising one or more loud speakers (17) disposed in a casing (11) in such manner that a prescribed radiating part of these loud speakers can irradiate an acoustic pressure to the exterior of the casing, the enclosure being provided, for the purpose of protection against parasitic radiation, with at least one lossy electric element, characterised in that the said lossy electric element is constituted by a screen comprising a covering or sheath (55) for at least some and preferably all the constituent elements, namely:

conductive cables (40, 41) connecting the loud speakers to a general terminal;

the magnet (46) of each loud speaker;

a supporting rim (56) projecting radially from each loud speaker;

a base (26) of the casing (11);

the said screen being realised in a dielectric material of which the multiplicative product of the resistivity and the dielectric constant provides a specific time constant greater than $2.10^{15}$ seconds.

2. Acoustic enclosure according to claim 1 in which at least one of the loud speakers comprises a conductive electric coating (57) on at least part of its membrane, characterised in that the said coating is connected electrically to one of the connection terminals (48) of the said loud speaker.

3. Acoustic enclosure according to claim 2, characterised in that the said coating is metallic.

4. Apparatus associated with an enclosure according to any of the foregoing claims, characterised in that at least one of its elements is covered by a screen as defined in claim 1.

5. A screen as defined in claim 1 characterised in that the material is chosen from the group comprising polytetrafluroethylene, ethylene propylene fluoride, a pure polystyrene and barium titanate.

## Ansprüche

1. Akustisches Gehäuse (10) mit einem oder mehreren Lautsprechern (17), die in einem Kasten (11) so angeordnet sind, daß ein sogenannter Strahlungsteil (49) dieser Lautsprecher einen akustischen Druck aus dem Kasten heraus abstrahlen kann, wobei das Gehäuse zum Schutz gegen Störstrahlungen mit mindestens einem elektrischen Element mit Verlusten versehen ist, dadurch gekennzeichnet, daß dieses Element mit Verlusten aus einer Abschirmung (55) zur Verkleidung oder Umhüllung von mindestens manchen und vorzugsweise allen seiner Bestandteile besteht, wie:
   - leitende Kabel (40, 41), die die Lautsprecher mit einem Hauptverbinder verbinden;
   - der Magnet (46) jedes Lautsprechers;
   - eine radial hervorstehende Auflagelippe (56) jedes Lautsprechers;
   - Wand (26) des Kastens (11);
   wobei die Abschirmung aus einem dielektrischen Werkstoff besteht, dessen Resistivität und dielektrische Konstante sich durch Multiplikation zu einer spezifischen Zeitkonstante von über $2.10^{15}$ Sekunden kombinieren.

2. Akustisches Gehäuse nach Anspruch 1, von dem mindestens einer der Lautsprecher eine elektrisch leitende Verkleidung (57) auf mindestens einem Teil seiner Membran besitzt, dadurch gekennzeichnet, daß diese Verkleidung elektrisch mit einem der Verbindungsanschlüsse (48) dieses Lautsprechers verbunden ist.

3. Akustisches Gehäuse nach Anspruch 2, dadurch gekennzeichnet, daß die Verkleidung aus Metall besteht.

4. Einem Gehäuse nach einem der vorhergehenden Ansprüche zugeordnete Einrichtungen, dadurch gekennzeichnet, daß mindestens eines ihrer Elemente mit einer Abschirmung gemäß Anspruch 1 bedeckt ist.

5. Abschirmung nach Anspruch 1, dadurch gekennzeichnet, daß der Werkstoff, aus dem sie besteht, aus der Gruppe ausgewählt ist, die Polytetrafluorethylen, Fluorethylenpropylen, einem sehr harten Polystyrol, Bariumtitanat besteht.

# FIG.1

# FIG.2